# EUROPÄISCHE PATENTANMELDUNG

(11) **EP 2 148 439 A1**
(43) Veröffentlichungstag der Anmeldung: **27.01.2010**
(21) Anmeldenummer: 08013200.4
(22) Anmeldetag: 22.07.2008
(51) Int. Cl.: H03H 9/24, H03H 9/02, G01N 33/543

(54) **Hochfrequenzantrieb und Detektion elektromechanischer Systeme**

(71) Anmelder: Ludwig-Maximilians-Universität München, 80539 München (DE)
(72) Erfinder: Unterreithmeier, Quirin, 81373 München (DE)
(74) Vertreter: Müller-Boré & Partner Patentanwälte

(57) **Zusammenfassung**

Die vorliegenden Erfindung betrifft insbesondere einen Resonator und ein Verfahren zur Resonanzerzeugung insbesondere mittels eines solchen Resonators. Dabei umfasst der Resonator zumindest eine Elektrode zur Erzeugung eines zumindest bereichsweise inhomogenen, elektrischen Feldes. Außerdem umfasst der Resonator ein Schwingungselement, das zumindest bereichsweise in dem inhomogenen elektrischen Feld der zumindest einen Elektrode angeordnet ist und in Richtung des Feldgradienten des inhomogenen elektrischen Feldes rückstellfähig auslenkbar ist, sowie einen elektrischen Signalgeber, welcher ausgelegt ist, das elektrische Potential der zumindest einen Elektrode zu variieren.

## Beschreibung

Die vorliegende Erfindung betrifft einen mechanischen Resonator mit hoher Güte und einer besonders geringen Störempfindlichkeit.

Resonatoren, insbesondere mikro- und nanomechanische Resonatoren werden unter anderem in der Sensorik eingesetzt. Verbreitete Anwendungen von mikroelektro-mechanischen Systemen (MEMS) sind beispielsweise Sensoren für Druck-, Kraft-, Bewegungs- bzw. Beschleunigungs- und chemische Messungen. In zunehmendem Maße steigt auch das Interesse an der Nutzung von mikro- und nanomechanischen Systemen in der Signalverarbeitung. Mögliche Einsatzgebiete für solche Systeme ergeben sich in der Signalverarbeitung beispielsweise als Oszillatoren oder Resonatoren in Frequenzfiltern. Die Vorzüge mechanischer Systeme gegenüber rein elektrischen Schaltkreisen liegt insbesondere in der geringen Leistungsaufnahme und einer hohen Güte. Darüber hinaus eröffnen mikromechanische Systeme in der Sensorik einen direkteren Zugang zur Detektion insbesondere mechanischer Größen, als dies durch rein elektronische Systeme möglich wäre. Die Ansprüche an Zuverlässigkeit und Präzision von Resonatoren steigen aber ebenso wie die Möglichkeit einer kostengünstigen Herstellung und Integration in Sensor- und Singalverarbeitungssystemen mit jedem neuen Einsatzgebiet und steigender Integrationsdichte.

Es ist somit Aufgabe der vorliegenden Erfindung eine verbesserte Güte und eine verringerte Störempfindlichkeit bei Messungen und in der Signalverarbeitung durch Verwendung mechanischer Resonatoren zu erreichen. Diese Aufgabe wird durch einen Resonator, dessen Verwendung, einen Sensor, einen Taktgeber und ein Verfahren mit den jeweils in den unabhängigen Ansprüchen angegebenen Merkmalen gelöst. Bevorzugte Ausführungsformen sind Gegenstand der abhängigen Ansprüche.

Die vorliegende Erfindung stellt somit insbesondere einen Resonator bereit, welches umfasst:
- zumindest eine erste Elektrode zur Erzeugung eines zumindest bereichsweise inhomogenen, elektrischen Feldes;
- ein Schwingungselement, das zumindest bereichsweise in dem inhomogenen elektrischen Feld der zumindest einen Elektrode angeordnet ist und in Richtung des Feldgradienten des inhomogenen elektrischen Feldes rückstellfähig auslenkbar ist; und
- einen elektrischen Signalgeber, welcher ausgelegt ist, das elektrische Potential der zumindest einen Elektrode zu variieren.

Die zumindest eine erste Elektrode ist somit ausgelegt, in zumindest einem räumlichen Bereich ein inhomogenes, elektrischen Feld zu erzeugen. Die Position und Ausdehnung ebenso wie der Grad der Inhomogenität des elektrischen Feldes bzw. des inhomogenen Feldbereichs hängt dabei insbesondere von der Geometrie der zumindest einen ersten Elektrode ab. Das Schwingungselement ist dabei zumindest teilweise bzw. bereichsweise in dem Bereich angeordnet, in dem die zumindest eine erste Elektrode ein inhomogenes, elektrisches Feld erzeugt bzw. erzeugen kann. Insbesondere ist zumindest ein auslenkbarer Abschnitt bzw. Schwingungsabschnitt zumindest teilweise in diesem Bereich angeordnet.

Dabei wurde erfindungsgemäß erkannt, dass das Schwingungselement durch das elektrische Feld von Elektrodenmitteln wie z.B. der mindestens einen ersten Elektrode polarisiert wird und aufgrund der Inhomogenität des elektrischen Feldes parallel zum Feldgradienten aus einer Ruheposition ausgelenkt wird. Das elektrisch polarisierbare Schwingungselement erfährt nämlich eine von der elektrischen Feldstärke abhängige elektrische Polarisation. Durch diese elektrische Polarisation wirkt auf das Schwingungselement eine vom Gradienten des elektrischen Felds abhängige und insbesondere dazu im Wesentlichen proportionale Kraftkomponente parallel zum Gradienten des elektrischen Feldes. Als inhomogen wird dabei insbesondere ein elektrisches Feld bezeichnet, welches in zumindest einer Raumrichtung nicht konstant ist. Die Kraft auf das Schwingungselement wirkt dabei insbesondere im Wesentlichen in Richtung zum höheren elektrischen Feld hin. Diese Kraft bewirkt damit eine zumindest teilweise Auslenkung des Schwingungselements. Insbesondere ist das Schwingungselement vorzugsweise im Wesentlichen elastisch auslenkbar. Es wirkt also insbesondere eine mechanische Rückstellkraft auf das bzw. in dem Schwingungselement in Richtung einer feldfreien Ruhestellung des Schwingungselements.

Durch die Variation des elektrischen Potentials der zumindest einen ersten Elektrode mittels des Signalgebers wird das inhomogene elektrische Feld und damit die Auslenkung des Schwingungselements variiert. Außerdem wird durch die Variation des elektrischen Potentials und der damit verbundenen Variation des elektrischen Feldes auch die Polarisation des Schwingungselements variiert. Insbesondere im Zusammenspiel mit einer elastischen Rückstellkraft führt dies zu einer besonders effizienten Schwingungsanregung des Schwingungselements. Da die elektrische Polarisation und somit die Auslenkung des Schwingungselements sehr stark von dem von der zumindest einen ersten Elektrode erzeugten elektrischen Feld und insbesondere von der Inhomogenität des elektrischen Feldes abhängt, koppelt das Schwingungselement sehr effizient an das elektrische Feld der zumindest einen ersten Elektrode während es im Gegensatz bzw. im Vergleich dazu relativ unempfindlich auf externe bzw. weiter entfernte Quellen elektrischer Felder reagiert. Damit erreicht der erfindungsgemäße Resonator eine besondere niedrige Störempfindlichkeit. Außerdem wurde erkannt, dass dieser erfindungsgemäße Resonator eine verbesserte Temperaturstabilität aufweist als dies beispielsweise bei Oszillatoren auf Basis von Schwingquarzen bekannt ist.

Der erfindungsgemäße Resonator ist insbesondere nicht auf ein Schwingungselement aus metallisch leitfähigem Material angewiesen. Statt dessen kann das elektrisch polarisierbare Material des Schwingungselements unmittelbar auf seine gewünschten mechanischen Eigenschaften optimiert werden, um den Resonator an die gewünschten Betriebsbedingungen anzupassen und zudem die Güte des Resonators zu optimieren. Dazu weist zumindest ein rückstellfähig auslenkbarer Schwingungsabschnitt des Schwingungselements vorzugsweise kein metallisches und/oder metallisch leitfähiges Material auf. Einerseits wird durch das Vermeiden metallisch leitfähiger Materialien die Beeinflussung der Auslenkung und damit der Schwingung des Schwingungselements durch externe elektrische und/oder magnetische und/oder elektromagnetische Störfelder möglichst gering gehalten. Andererseits werden damit auch die bei der Verformung von Metallen oft auftretenden mechanischen Verluste bzw. Reibungen insbesondere aufgrund einer teilweise kaum vermeidbaren plastischen Verformung solcher Materialien deutlich verringert. Damit lässt sich eine besonders hohe Güte des Resonators erreichen. Das Schwingungselement umfasst somit vorzugsweise elektrisch isolierendes Material. Besonders bevorzugt wird das Schwingungselement im Wesentlichen von einem Isolator bzw. elektrisch isolierenden Material gebildet. Elektrisch isolierendes Material wird besonders wenig von externen elektrischen und/oder magnetischen und/oder elektromagnetischen Störfeldern beeinflusst.

Vorzugsweise ist das Schwingungselement von einem homogenen Material gebildet. Durch ein homogenes Material des Schwingungselements erreicht man eine besonders gleichmäßige Verteilung der mechanischen Spannungen im Schwingungselement. Außerdem werden damit mechanische Reibungsverluste an Materialgrenzflächen bei der mechanischen Verformung des Schwingungselements während eines Schwingungsvorgangs vermieden. Beides führt zu einer Verbesserung der Güte des Resonators.

Vorzugsweise umfasst das Schwingungselement Material mit einer Dielektrizitätskonstante von mindestens 2, vorzugsweise mindestens 3, besonders bevorzugt in einem Bereich von 3 bis 60, am meisten bevorzugt in einem Bereich von 4 bis 11. Damit ist eine besonders effiziente Schwingungsanregung bei gleichzeitig niedriger Störung durch externe Störfelder möglich. Vorzugsweise umfasst das Schwingungselement Siliziumnitrid und/oder Silizium und/oder Siliziumoxid und/oder Siliziumcarbid und/oder GaAs und/oder Quarz und/oder Keramiken. In einer anderen bevorzugten Ausführungsform umfasst das Schwingungselement ferroelektrisches Material insbesondere mit einer Dielektrizitätskonstante von vorzugsweise bis zu etwa 5000. Besonders bevorzugt besteht das Schwingungselement und insbesondere alle während einer Auslenkung bzw. Schwingung des Schwingungselements elastisch verformten Bereiche des Schwingungselements im Wesentlichen homogen aus Siliziumnitrid.

Vorzugsweise ist das Schwingungselement über einen ersten Endabschnitt und einen zweiten Endabschnitt direkt oder indirekt an einem Trägersubstrat angeordnet und/oder befestigt und zumindest in einem zwischen den beiden Endabschnitten angeordneten und vorzugsweise vom Trägersubstrat beabstandeten Schwingungsabschnitt zugverspannt. Dabei ist der Schwingungsabschnitt vorzugsweise nach Art einer Saite oder eines Balkens oder eines Stegs ausgebildet.

In einer anderen bevorzugten Ausführungsform ist das Schwingungselement nur über einen ersten Endabschnitt am Trägersubstrat angeordnet und/oder befestigt. Ein zweiter Endabschnitt ist dabei vorzugsweise unter elastischer Verformung des Schwingungselements bewegbar. Somit bildet in dieser Ausführungsform insbesondere der zweite Endabschnitt den Schwingungsabschnitt des Schwingungselements.

Vorzugsweise weist das Schwingungselement eine Eigenfrequenz bzw. Resonanzfrequenz für eine Schwingung um die feldfreie Ruhelage von mindesten 1 kHz, vorzugsweise mindestens 10 kHz, noch mehr bevorzugt mindestens 0,1 MHz, am meisten bevorzugt mindestens 1 MHz auf. Als feldfreie Ruhelage wird die insbesondere die bei Abwesenheit eines elektrischen Feldes und ohne weitere mechanische Einwirkung von außen vom Schwingungselement eingenommene Ruhelage bzw. Form betrachtet. Als Eigenfrequenz bzw. Resonanzfrequenz wird vorzugsweise die Frequenz einer Grundschwingung des Schwingungselements, also derjenigen Eigenschwingung des Schwingungselements mit der niedrigsten Frequenz bzw. mit der geringsten Anzahl an Schwingungsknoten verstanden.

In einer bevorzugten Ausführungsform umfasst der Resonator außerdem zumindest eine zweite Elektrode, welche ausgelegt ist, zusammen mit der zumindest einen ersten Elektrode das zumindest bereichsweise inhomogene, elektrische Feld zu erzeugen. Dazu liegen die zumindest zwei Elektroden vorzugsweise auf unterschiedlichem elektrischen Potential und besondere bevorzugt wird die elektrische Potentialdifferenz, also die Spannung zwischen den zwei Elektroden vom Signalgeber variiert. In einer bevorzugten Ausführungsform sind die erste und zweite Elektrode zumindest teilweise in einer gemeinsamen Ebene angeordnet, bzw. sie definieren bzw. spannen eine gemeinsame Ebene auf. Beispielsweise sind die beiden Elektroden langgestreckt ausgebildet und verlaufen im Wesentlichen zumindest Abschnittsweise parallel zueinander. Das Schwingungselement ist dabei vorzugsweise zumindest größtenteils nicht in der selben Ebene angeordnet und/oder es ist nicht zwischen den beiden Elektroden angeordnet. Vorzugsweise wird dadurch erreicht, dass das Schwingungselement in einem inhomogenen Feldbereich des von den beiden Elektroden erzeugten elektrischen Feldes angeordnet ist.

Vorzugsweise weist das Schwingungselement von der ersten und/oder zweiten Elektrode einen Abstand von höchstens 10 µm, vorzugsweise höchstens 5 µm, insbesondere höchstens 2 µm, noch mehr bevorzugt höchstens 1 µm und am meisten bevorzugt höchstens 0,5 µm auf. In einer besonders bevorzugten Ausführungsform weist das Schwingungselement von der ersten und/oder zweiten Elektrode eine Abstand im Bereich von etwa 50 nm bis etwa 300 nm auf. Vorzugsweise liegen die Abstände der beiden Elektroden ebenfalls in einem der vorzugsweise genannten Größenbereiche.

In einer bevorzugten Ausführungsform ist der elektrische Signalgeber ausgelegt, das elektrische Potential an der ersten Elektrode bzw. die elektrischen Spannung zwischen der ersten und zweiten Elektrode um einen Wert einer konstanten Vorspannung *V₀*, d.h. einen Offset-Wert herum zu variieren. Die konstante Vorspannung *V₀*, also der Offset-Wert des elektrischen Potentials bzw. der elektrischen Spannung führt dabei zu einem im zeitlichen Mittelwert nicht verschwindenden elektrischen Feld am Ort des Schwingungselements. Dadurch wird im zeitlichen Mittel eine elektrische Polarisation des polarisierbaren Schwingungselements bewirkt, wodurch das Schwingungselement besonders empfindlich auf eine Variation des elektrischen Potentials durch eine entsprechende Auslenkungskraft reagiert und sich zu einer Schwingung anregen lässt. Vorzugsweise ist der Wert der mittleren Abweichung oder mittleren Abweichungsquadrats (RMS, root mean square) der Variationen um den Wert der Vorspannung herum sehr viel kleiner als der Wert der Vorspannung selbst, insbesondere um einen Faktor von mindestens 10, vorzugsweise mindestens 10², noch mehr bevorzugt mindestens 10⁴. So könnte als Wert der Vorspannung V₀ insbesondere ein Wert von etwa 0,5 V bis etwa 50 V vorgesehen sein, während die Abweichungen von diesem Wert aufgrund der vom Signalgeber bereitgestellten bzw. erzeugten Variation nicht größer als etwa 100 mV, vorzugsweise nicht größer als etwa 10 mV, besonders bevorzugt nicht größer als etwa 1 mV ist. Sogar bei Variationen bzw. Modulationen von nicht mehr als etwa 1 µV werden in einem Resonator gemäß einer bevorzugten Ausführungsform der vorliegenden Erfindung noch Schwingungen des Schwingungselements angeregt. In einer weiteren bevorzugten Ausführungsform kann die Vorspannung V₀ auch kleiner als 0,5 V, insbesondere sogar Null sein.

Aufgrund solch niedriger Anregungssignale kann in einem Resonator gemäß der vorliegenden Erfindung bereits mit äußerst niedrigen Anregungsleistungen eine Resonanz hervorgerufen werden. So beträgt die Anregungsleistung vorzugsweise nicht mehr als 1 mW (10⁻³ W) oder sogar nicht mehr als 1 µW (10⁻⁶ W), besonders bevorzugt nicht mehr als 1 nW (10⁻⁹ W) oder sogar nicht mehr als 1 pW (10⁻¹² W).

Durch die konstante Vorspannung V₀, wird neben einer von dieser Vorspannung abhängigen Polarisation des Schwingungselements auch eine im Wesentlichen konstante Kraft auf das Schwingungselement bewirkt, die zu einer von der feldfreien Ruhelage des Schwingungselements abweichenden Schwingungsnullpunktlage des Schwingungselements führt, d.h. das Schwingungselement führt Schwingungen um eine von der Vorspannung *V₀* abhängige Nullpunktlage aus. Insbesondere ist eine Resonanzfrequenz bzw. Eigenfrequenz *fᵣ* des Schwingungselement von der Schwingungsnullpunktlage und damit von der Vorspannung *V₀* abhängig. Somit lässt sich vorzugsweise mittels der Vorspannung *V₀* eine Änderung, insbesondere eine Feineinstellung der Resonanzfrequenz *fᵣ* des Schwingungselements vornehmen. Damit betrifft die vorliegende Erfindung in einer bevorzugten Ausführungsform eine elektrisch einstellbaren bzw. steuerbaren bzw. trimmbaren bzw. abgleichbaren Resonator.

Besonders bevorzugt ist der elektrische Signalgeber ausgelegt, das elektrische Potential an der ersten Elektrode bzw. die elektrische Spannung zwischen der ersten und zweiten Elektrode mit zumindest einer Anregungsfrequenz *fₑ* periodisch zu variieren. Insbesondere wird dabei das elektrische Potential an der ersten Elektrode bzw. die elektrische Spannung zwischen der ersten und zweiten Elektrode um den Wert der konstanten Vorspannung *V₀* herum mit der Anregungsfrequenz *fₑ* periodisch variiert.

Vorzugsweise umfasst der Resonator außerdem einen Detektor bzw. eine Detektionseinrichtung zur Detektion bzw. zum Detektieren einer Schwingung bzw. Oszillation des Schwingungselements. In einer bevorzugten Ausführungsform umfasst die Detektionseinrichtung ein optisches Detektionselement, das insbesondere ausgelegt ist, eine Änderung einer Reflexion eines Lichtstrahl am Schwingungselements aufgrund einer Schwingung des Schwingungselements zu erfassen. In einer weiteren bevorzugten Ausführungsform umfasst die Detektionseinrichtung ein piezoelektrisches Detektionselement, das ausgelegt ist, eine von einer mechanischen Verformung des Schwingungselements während einer Schwingung des Schwingungselements bewirkte Piezospannung auszugeben. Dazu umfasst das Schwingungselement vorzugsweise piezoelektrisches Material. Alternativ oder zusätzlich ist piezoelektrisches Material direkt oder indirekt an das Schwingungselement, insbesondere an einen sich während einer Schwingung des Schwingungselements mechanisch bewegenden und/oder verformenden Bereichs des Schwingungselements angeordnet.

In einer weiteren bevorzugten Ausführungsform umfasst die Detektionseinrichtung ein magnetisches Detektionselement, welches ausgelegt ist, eine durch eine Schwingung des Schwingungselements direkt oder indirekt hervorgerufene Lorentz-Kraft oder Hall-Spannung bei Anwesenheit eines magnetischen Feldes zu detektieren. In einer weiteren bevorzugten Ausführungsform umfasst die Detektionseinrichtung ein elektrisches Detektionselement, welches insbesondere kapazitiv an das elektrisch polarisierte Schwingungselement koppelt und ausgelegt ist, ein durch eine Schwingung des Schwingungselements aufgrund der kapazitiven Kopplung bewirktes elektrisches Signal z.B. in Form eines sich ändernden elektrischen Potentials auszugeben. Insbesondere könnten hierzu eine oder mehrere Detektionselektroden bereitgestellt sein, deren elektrisches Potential durch eine Bewegung des polarisierten Schwingungselements über das sich damit bewegenden elektrische Dipolfeld beeinflusst wird.

In einer bevorzugten Ausführungsform ist die Anregungsfrequenz *fₑ* ein ganzzahliges Vielfaches der Resonanzfrequenz *fᵣ* des Schwingungselements. In einer weiteren bevorzugten Ausführungsform steht die Resonanzfrequenz *fᵣ* zur Anregungsfrequenz *fₑ* im Verhältnis *m*/*n*, wobei *m* und *n* ganze Zahlen sind. Vorzugsweise liegen die Zahlen m und n im Bereich von 1 bis 10. Besonders bevorzugt ist m=2, wobei insbesondere n im Bereich von 1 bis 5 liegt.

Vorzugsweise stimmen die Anregungsfrequenz *fₑ* und die Resonanzfrequenz *fᵣ* nicht überein. Damit wird eine besonders effiziente Entkopplung einer Anregung von einer Detektion bei gleichzeitig guter Kopplung des Schwingungselements an das variierende, inhomogene elektrische Feld erreicht. Insbesondere lässt sich das Schwingungselement vorzugsweise nach Art eines parametrischen Oszillators durch eine Anregungsfrequenz *fₑ*, die nicht mit der Resonanzfrequenz *fᵣ* übereinstimmt, sondern beispielsweise ein ganzzahliges Vielfaches davon darstellt, zu einer Schwingung bei der Resonanzfrequenz *fᵣ* anregen.

Eine bevorzugte Entkopplung der Schwingungsanregung von einer Detektion der Schwingung ist insbesondere darauf zurückzuführen, dass ein eventuelles Übersprechen bzw. ein Nebensignaleffekt, insbesondere ein direktes elektrisches Übersprechen von der elektrischen Anregungseinrichtung, also der zumindest einen Elektrode, eventuellen Zuleitungen und/oder dem elektrischen Signalgeber auf den Schwingungsdetektor durch eine zeitliche Mittelung sehr leicht separiert bzw. gefiltert werden kann.

In einem weiteren Aspekt betrifft die Erfindung einen Sensor zum Detektieren und/oder Messen bestimmter Partikel, insbesondere Atome, Moleküle oder Komplexe einer bestimmten chemischen bzw. biologischen Substanz bzw. Verbindung. Insbesondere umfasst ein solcher Sensor einen Resonator gemäß der Erfindung oder einer bevorzugten Ausführungsform davon und ein am Schwingungselement angeordnetes Ankerelement bzw. Kopplungselement zur Verankerung bzw. Kopplung eines zu detektierenden Partikels bzw. Teilchens am Schwingungselement. Durch die Kopplung des Partikels am Schwingungselement wird die für eine resonante Anregung in Schwingung zu versetzende Masse vergrößert, wodurch die Resonanzfrequenz sinkt. Die resultierende Resonanzfrequenz hängt damit von der Masse des angekoppelten Partikels ab. Durch Messung der Resonanzfrequenz lässt sich damit auf die Anwesenheit und/oder die Masse eines angekoppelten Partikels schließen. In einer bevorzugten Ausführungsform bildet der Sensor damit einen Massenanalysator bzw. Massensensor.

In einer weiteren bevorzugten Ausführungsform ist das Ankerelement mit einem ersten Endabschnitt zum Schwingungselement hin verbunden, während der andere, freie Endabschnitt des Ankerelements eine funktionale Gruppe zur selektiven Kopplung an eine bestimmte chemische bzw. biologische Gruppe bzw. Substanz ausgelegt ist. Vorzugsweise bildet die funktionale Gruppe einen Rezeptor für eine oder mehrere bestimmte chemische Elemente und/oder Verbindungen und/oder Komplexe. In einer bevorzugten Ausführungsform koppelt das Ankerelement selektiv an DNA. Durch die Auswahl des Ankerelements bzw. Rezeptors lässt sich die zu detektierende Substanz festlegen. Vorzugsweise wird eine zu detektierende DNA durch die geeignete Auswahl des Ankerelements bzw. Rezeptors z.B. als Teil eines DNA-Strangs nach einem Schlüssel-Schloss-Prinzip festgelegt. Dabei koppelt nur die zum ausgewählten Ankerelement komplementäre DNA-Struktur an dieses Ankerelement. Das Anordnen bzw. Befestigen eines Ankerelements und/oder einer Vermittlerschicht als Kopplungselement an das Schwingungselement wird insbesondere als Funktionalisierung des Schwingungselements bezeichnet. In Bezug auf weitere bevorzugte Funktionalisierungen des Schwingungsungselements, die in entsprechender Weise für einen erfindungsgemäßen Sensor angewandt werden können, wird auf WO 01/33226 A1 verwiesen.

Vorzugsweise sind am Schwingungselement eine Vielzahl von Ankerelementen des gleichen Typs angeordnet. Während einer Detektion einer Substanz ergibt sich damit je nach vorhandener Konzentration der Substanz nacheinander eine Besetzung der Ankerelemente mit den Partikeln der Substanz. In Abhängigkeit von einer zeitlichen Änderung der Resonanzfrequenz lässt sich damit eine Konzentration bzw. ein Partialdruck der detektierten Substanz in der vorzugsweise gasförmigen Umgebung des Sensor ermitteln.

In einer weiteren bevorzugten Ausführungsform sind mehrere verschiedene Ankerelemente bzw. Rezeptoren an das Schwingungselement angeordnet, an die jeweils bestimmte Partikel bzw. Teilchen bzw. Moleküle bzw. Komplexe jeweils einer bestimmten, zu detektierenden Substanz selektiv ankoppeln. Durch die Auswahl der Ankerelemente bzw. Rezeptoren lassen sich die zu detektierenden Substanzen festlegen. Dabei werden vorzugsweise Ankermoleküle für Substanzen mit Partikeln unterscheidbarer Masse angeordnet. Damit lässt sich beim Ankoppeln eines jeweiligen Partikels eine für diese Substanz aufgrund der spezifischen Partikelmasse spezifische Verschiebung der Resonanzfrequenz ermitteln, was eine besonders einfache Unterscheidung der verschiedenen Substanzen zulässt. In einer anderen bevorzugten Ausführungsform werden verschiedene Ankerelemente für die Detektion verschiedener Partikel an verschiedenen Positionen des Schwingungselement angeordnet. Insbesondere an Positionen, welche bei einer Schwingung des Schwingungselements eine unterschiedliche Amplitude der Schwingung bzw. Schwingungsauslenkung erfahren. Damit beeinflussen die an die verschiedenen Ankerelemente gekoppelten Partikel die Resonanzfrequenz in Abhängigkeit von der Position des Ankerelements unterschiedlich stark, wodurch sich selbst Substanzen mit Partikeln von etwa gleicher Masse aufgrund Ihrer selektiven Ankopplung an bestimmte Positionen des Schwingungselements über die damit verbundene spezifische Verschiebung bzw. Veränderung der Resonanzfrequenz unterscheiden lassen.

In einer weiteren bevorzugten Ausführungsform umfasst der Sensor eine Vielzahl von Resonatoren gemäß der vorliegenden Erfindung oder einer bevorzugten Ausführungsform, wobei insbesondere an jedem Schwingungselement dieser Resonatoren zumindest ein Ankerelement angeordnet ist und die Ankerelemente verschiedener Resonatoren zur Verankerung jeweils unterschiedlicher Partikel ausgelegt sind. Es wird damit insbesondere ein Resonatorfeld bzw. Resonatorarray bereitgestellt, mit dessen Hilfe eine Vielzahl verschiedener Substanzen detektiert werden kann.

In einem weiteren Aspekt der Erfindung wird ein Beschleunigungssensor bereitgestellt, welcher zumindest einen erfindungsgemäßen Resonator als Sensorelement umfasst. Demnach wird ein Resonator gemäß der vorliegenden Erfindung oder einer bevorzugten Ausführungsform davon vorzugsweise als Beschleunigungssensor verwendet. Diese Verwendung umfasst insbesondere ein Detektieren einer Änderung einer Resonanzfrequenz des Resonators während bzw. aufgrund einer Beschleunigung des Resonators; und ein Ermitteln eines Wertes der Beschleunigung aus der detektierten Änderung der Resonanzfrequenz. Dabei ergibt sich insbesondere durch eine aufgrund der Beschleunigung des Resonators auf das Schwingungselement wirkende Kraft eine Verschiebung der Resonanzfrequenz. Dieser Effekt ist vergleichbar mit der Verschiebung der Resonanzfrequenz durch das Anlegen einer konstanten Vorspannung *V₀* und die damit bewirkte Kraft auf das Schwingungselement. In einer bevorzugten Ausführungsform wird für die Messung der Beschleunigung die Verschiebung bzw. Änderung der Resonanzfrequenz insbesondere mittels der Detektionseinrichtung detektiert und die Beschleunigung aus der detektierten Verschiebung bzw. Änderung abgeleitet bzw. ermittelt. In einer anderen bevorzugten Ausführungsform wird die Resonanzfrequenz während der Beschleunigung insbesondere durch Nachregeln der elektrischen Vorspannung V₀ im Wesentlichen konstant gehalten. Aus dem dafür erforderlichen Wert der

Vorspannung V₀ wird die Beschleunigung abgeleitet bzw. ermittelt.

In einem weiteren Aspekt wird ein Resonator gemäß der vorliegenden Erfindung oder einer bevorzugten Ausführungsform davon als Frequenzfilter verwendet. Insbesondere in der Signalverarbeitung werden Bandpassfilter benötigt. Ein erfindungsgemäßer Resonator ermöglicht die Nutzung hoher Frequenzen und Güten und ist insbesondere in der Frequenz verstimmbar. Je schmalbandinger ein Filter ist, desto mehr Information lässt sich innerhalb eines Frequenzbandes übertragen. Andererseits ist es besonderes vorteilhaft, wenn die Resonanz eines schmalbandigen Filters möglichst präzise mit der zu filternden Frequenz übereinstimmt. Ein vorzugsweise abstimmbarer Filter, d.h. ein Filter mit einem Resonator, dessen Resonanzfrequenz abstimmbar bzw. einstellbar ist, ermöglicht dabei vorzugsweise auch einen Ausgleich bzw. eine Korrektur des Einflusses von Fertigungsungenauigkeiten auf die Resonanzfrequenz des Resonators. In einer weiteren Ausführungsform werden eine Vielzahl erfindungsgemäßer Resonatoren in einem Spektrumanalysator verwendet. Dabei werden vorzugsweise mehrere abstimmbare Resonatoren gemäß einer bevorzugten Ausführungsform der Erfindung parallel geschaltet. Damit lässt sich ein großer Frequenzbereich mit hoher Auflösungsgenauigkeit abdecken.

Besonders bevorzugt wird ein erfindungsgemäßer Resonator monolithisch mit einem elektrischen Schaltkreis, insbesondere einem Halbleiterschaltkreis integriert. Im Vergleich zu derzeitigen SAW-Filtern z.B. in Mobiltelefonen, welche auf einem eigenen Chip angeordnet sind, lassen sich damit die Fertigungskosten deutlich senken. Durch die geringe Leistungsaufnahme solcher erfindungsgemäßer Filterkomponenten kann damit insbesondere die Akkulaufzeit mobiler Geräte verbessert werden.

In einem weiteren Aspekt stellt die Erfindung einen Taktgeber bereit, welcher einen Resonator gemäß der vorliegenden Erfindung oder einer bevorzugten Ausführungsform davon umfasst, wobei der elektrische Signalgeber als elektrischer Schwingkreis ausgebildet ist, der ausgelegt ist, das elektrische Potential der zumindest einen ersten Elektrode breitbandig zu variieren.

Der elektrische Signalgeber ist also insbesondere ausgelegt, ein elektrisches Signal mit einer Vielzahl, insbesondere einem Kontinuum von Frequenzkomponenten zu generieren bzw. auszugeben und insbesondere an die zumindest eine Elektrode zu übertragen. Vorzugsweise liegen die Frequenzkomponenten des vom elektrischen Signalgebers ausgegebenen Signals im Wesentlichen in einem Bereich von etwa 1/10 der Resonanzfrequenz bis etwa der 10-fachen Resonanzfrequenz, besonders bevorzugt von etwa 1/3 der Resonanzfrequenz bis etwa der 3-fachen Resonanzfrequenz. "Im Wesentlichen" soll dabei insbesondere zum Ausdruck bringen, dass zumindest 50% der elektrischen Signalleistung des Schwingungsgebers von Frequenzkomponenten in dem angegebenen Frequenzbereich getragen wird. Noch mehr bevorzugt sind dies zumindest 75% der elektrischen Signalleistung, oder sogar zumindest 90%. Am meisten bevorzugt sind dies sogar zumindest 99% der elektrischen Signalleistung. Durch die niedrige Signalleistung insbesondere für Frequenzkomponenten unterhalb von etwa 1/100 oder etwa 1/25 oder etwa 1/10 der Resonanzfrequenz lässt sich eine eventuell unerwünschte Modulation der Resonanzfrequenz durch solche Frequenzkomponenten verhindern.

In einem weiteren Aspekt bietet die vorliegende Erfindung ein Verfahren zur Resonanzerzeugung durch zeitliches Variieren eines inhomogenen elektrischen Feldes in zumindest einem Bereich eines mechanischen Schwingungselements. Durch das inhomogene elektrische Feld lässt sich auf das mechanische Schwingungselement durch dessen elektrische Polarisation eine Auslenkungskraft ausüben. Die Variation dieser Kraft ermöglicht damit eine effiziente Schwingungsanregung. Da diese Schwingungsanregung insbesondere auf einer vom inhomogenen, elektrischen Feld bewirkten Polarisation des Schwingungselements und deren Kraftwirkung durch die Inhomogenität des elektrischen Feldes beruht, ist es nicht erforderlich elektrisch leitfähige Materialien für das Schwingungselement bereitzustellen. Außerdem wird damit eine sehr störungsarme Resonanzerzeugung erreicht.

Das Verfahren umfasst dabei insbesondere ein Bereitstellen eines Schwingungselements, welches zumindest bereichsweise elastisch bzw. rückstellfähig auslenkbar ist. Vorzugsweise umfasst das Verfahren ein Erzeugen eines inhomogenen elektrischen Feldes zumindest teilweise in einem Bereich, in dem das Schwingungselement auslenkbar ist. Insbesondere umfasst das Erzeugen eines inhomogenen elektrischen Feldes ein elektrisches Polarisieren des Schwingungselements. Besonders bevorzugt wird dabei ein elektrisch isolierendes Schwingungselement bzw. ein dielektrisches Schwingungselement bereitgestellt und zumindest bereichsweise elektrisch polarisiert. Insbesondere wird das Schwingungselement im Bereich eines inhomogenen elektrischen Feldes elektrisch polarisiert. Dabei umfasst das Verfahren ein zeitliches Verändern bzw. Variieren des inhomogenen elektrischen Feldes in einem elektrisch isolierenden Bereich des Schwingungselements. In einer bevorzugten Ausführungsform wird das Schwingungselement wie in einer der bevorzugten Ausführungsformen eines erfindungsgemäßen Resonators ausgelegt bzw. bereitgestellt bzw. angeordnet.

Vorzugsweise umfasst das zeitliche Variieren des inhomogenen elektrischen Feldes ein zeitliches Variieren eines elektrischen Potentials zumindest einer ersten Elektrode. Besonders bevorzugt umfasst das zeitliche Variieren des inhomogenen elektrischen Feldes ein zeitliches Variieren einer elektrischen Spannung zwischen einer ersten und einer zweiten Elektrode. Am meisten bevorzugt umfasst das zeitliche Variieren des inhomogenen elektrischen Feldes ein Anlegen einer elektrischen Spannung zwischen der ersten und zweiten Elektrode derart, dass die elektrische Spannung insbesondere periodisch und/oder symmetrisch um eine vorgegebene, im Wesentlichen konstante Vorspannung V₀ variiert wird.

Vorzugsweise umfasst das Verfahren einen oder mehrere Verfahrensschritte gemäß einer bevorzugten Betriebsweise oder Verwendung eines Resonators gemäß der vorliegenden Erfindung oder einer bevorzugten Ausführungsform davon. Insbesondere betrifft die Erfindung damit vorzugsweise ein Verfahren zur Detektion eines oder mehrerer Partikel und/oder zur Messung der Masse eines oder mehrerer Partikel. In einem weiteren Aspekt betrifft die Erfindung damit vorzugsweise ein Verfahren zur Bestimmung bzw. Messung einer Beschleunigung.

Die Erfindung wird nachfolgend anhand begleitender Zeichnungen bevorzugter Ausführungsformen beispielhaft beschrieben. Dabei zeigt:
- Fig. 1 A:: eine schematische Draufsicht auf einen Resonator gemäß einer ersten bevorzugten Ausführungsform der Erfindung;
- Fig. 1B:: eine perspektivische Ansicht eines Querschnitts durch einen Resonator gemäß der in Fig. 1 gezeigten Ausführungsform;
- Fig. 1C:: eine Querschnittsansicht des Resonators von Fig. 2 mit schematisch dargestellten Feldlinien des elektrischen Feldes bei einer angelegten Spannung an den Elektroden;
- Fig. 2A bis 2C:: schematische Querschnittsansichten von Resonatoren gemäß weiterer bevorzugter Ausführungsformen der vorliegenden Erfindung;
- Fig. 3:: eine perspektivische Ansicht zur schematischen Darstellung eines Resonators gemäß einer weiteren bevorzugten Ausführungsform der vorliegenden Erfindung;
- Fig. 4:: eine schematische Draufsicht auf einen Resonator gemäß einer weiteren bevorzugten Ausführungsform der Erfindung;
- Fig. 5:: eine Querschnittsansicht eines Sensor gemäß einer bevorzugten Ausführungsform der vorliegenden Erfindung;
- Fig. 6:: eine Graustufendarstellung einer gemessenen Schwingungsamplitude eines Schwingungselements in einem Resonator gemäß einer bevorzugten Ausführungsform;
- Fig. 7:: einen gemessenen Verlauf der Schwingungsamplitude eines Schwingungselements in einem Resonator gemäß einer bevorzugten Ausführungsform in Abhängigkeit von der Anregungsfrequenz;
- Fig. 8:: eine Graustufendarstellung einer gemessenen Schwingungsamplitude in Abhängigkeit der Anregungsfrequenz und der Anregungsleistung; und
- Fig. 9A bis 9F:: schematische Darstellungen einzelner Verfahrensschritte eines Herstellungsverfahrens für eine Vorrichtung gemäß einer bevorzugten Ausführungsform der vorliegenden Erfindung.

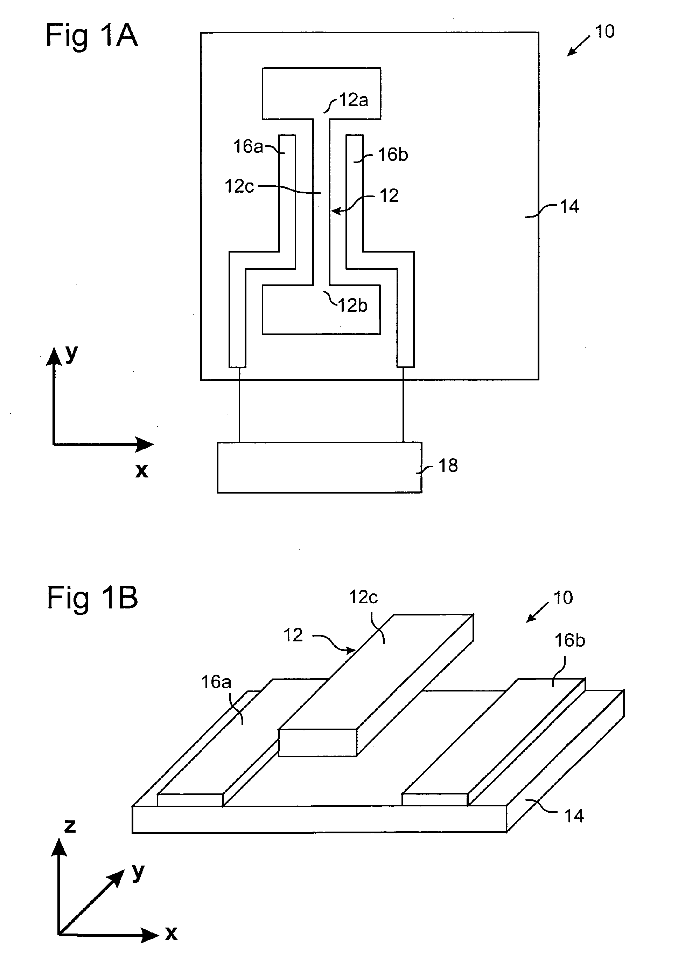

**Fig. 1A** zeigt eine schematische Draufsicht auf einen Resonator 10 gemäß einer ersten bevorzugten Ausführungsform der Erfindung. Der Resonator 10 umfasst ein Schwingungselement 12, welches sich im Wesentlichen entlang einer Längsrichtung von einem ersten Endabschnitt 12a zu einem zweiten Endabschnitt 12b des Schwingungselements 12 insbesondere über eine Länge von vorzugsweise zumindest etwa 100 nm, noch mehr bevorzugt zumindest etwa 1 µm, besonders bevorzugt in einem Bereich von etwa 3 µm bis etwa 200 µm erstreckt. Vorzugsweise ist das Schwingungselement zumindest abschnittsweise als langgestreckte Struktur nach Art einer Saite oder eines Balkens oder eines Stegs ausgebildet. Das Schwingungselement 12 ist in der gezeigten Ausführungsform von Fig. 1A über dessen Endabschnitte 12a, 12b bzw. an den Endabschnitten 12a, 12b mit einem Trägersubstrat 14 direkt oder indirekt fest verbunden. Das Trägersubstrat 14 weist dabei vorzugsweise eine Substratnormalenrichtung auf, welche in der Darstellung von Fig. 1A senkrecht zur Zeichenebene (x-y-Ebene) liegt. In der hier dargestellten bevorzugten Ausführungsform verläuft die Längsrichtung des Schwingungselements 12 vorzugsweise im Wesentlichen senkrecht zur Substratnormalenrichtung, d.h. das Schwingungselement 12 erstreckt sich im Wesentlichen parallel zu einer

Substratebene (x-y-Ebene in Fig. 1A). Eine direkte Verbindung des Schwingungselements 12 zum Trägersubstrat 14 könnte durch direktes Anordnen der Endabschnitte 12a, 12b an das Trägersubstrat 14 erreicht werden, während für eine indirekte Verbindung beispielsweise eine Zwischenschicht, wie z.B. eine später noch beschriebene Opferschicht, zwischen den Endabschnitten 12a, 12b und dem Trägersubstrat 14 angeordnet sein kann.

Zwischen den beiden fixierten Endabschnitten 12a, 12b umfasst das Schwingungselement 12 einen Schwingungsabschnitt 12c, welcher relativ zum Trägersubstrat 14 bewegbar und insbesondere um eine Ruhelage schwingungsfähig ist. Vorzugsweise umfasst das Schwingungselement 12 und insbesondere der Schwingungsabschnitt 12c elektrisch isolierenden Material. Besonders bevorzugt umfasst der Schwingungsabschnitt 12c bzw. das Schwingungselement 12 kein elektrisch leitfähiges Material insbesondere kein Metall bzw. metallisches Material. In einer bevorzugten Ausführungsform umfasst das Schwingungselement 12 und insbesondere der Schwingungsabschnitt 12c Silizimnitrid. Besonders bevorzugt ist das Schwingungselement 12, insbesondere zumindest der Schwingungsabschnitt 12c aus einem einheitlichen homogenen Material gebildet, vorzugsweise ohne ein anderes Material zu enthalten bzw. zu umfassen. Der Resonator ist allerdings nicht auf elektrisch isolierendes Material beschränkt. In einem weiteren Beispiel könnte der Schwingungselement 12 und insbesondere der Schwingungsabschnitt 12c elektrisch leitfähiges Material, insbesondere Metall umfassen oder sogar im wesentlichen homogen aus Metall bestehen.

In der gezeigten Ausführungsform ist der Schwingungsabschnitt 12c als mittlerer Abschnitt des Schwingungselements 12 ausgebildet und erstreckt sich in Längsrichtung (y-Richtung von Fig. 1 A) zwischen dem ersten Endabschnitt 12a und dem zweiten Endabschnitt 12b beispielsweise auf einer Länge von etwa 35 µm. Vorzugsweise ist der Schwingungsabschnitt 12c vom Trägersubstrat 14 beabstandet, was eine freie Schwingung des Schwingungsabschnitts 12c ermöglicht. Vorzugsweise umfasst das Schwingungselement 12 eine in Längsrichtung zugverspannte Schicht als Resonatormaterialschicht. Dadurch wird in besonders effizienter Weise eine geeignete Rückstellkraft auf den Schwingungsabschnitt 12c für eine Schwingung um die Ruhelage erreicht. Dabei werden die Kräfte der Zugverspannung nach Art einer gespannten Saite über die Endabschnitte 12a, 12b auf das Trägersubstrat 14 übertragen bzw. vom Trägersubstrat 14 aufgebracht. Je nach Spannung und Elastizität des Schwingungselements 12 weist das Schwingungselement 12 zumindest eine Resonanzfrequenz *fᵣ* für Schwingungen um die Ruhelage auf. In der dargestellten Ausführungsform ist das Schwingungselement 12 und insbesondere der Schwingungsabschnitt 12c zumindest in einer Richtung parallel zur Substratnormalenrichtung schwingungsfähig auslenkbar.

Der Resonator umfasst außerdem eine erste Elektrode 16a und eine zweite Elektrode 16b, welche voneinander beabstandet sind. In der dargestellten Ausführungsform weisen die Elektroden einen gegenseitigen Abstand von etwa 500 nm auf. Sie weisen elektrisch leitfähiges insbesondere metallisches Material auf. In einer bevorzugten Ausführungsform umfassen die Elektroden 16a, 16b Gold. Die beiden Elektroden 16a, 16b sind insbesondere so angeordnet, dass das Schwingungselement 12, insbesondere der Schwingungsabschnitt 12c zumindest teilweise nicht genau bzw. symmetrisch bzw. auf einer geraden Verbindungslinie zwischen den beiden Elektroden 16a, 16b angeordnet ist.

Die Anordnung des Schwingungselements 12 und der Elektroden 16a, 16c zueinander gemäß der ersten bevorzugten Ausführungsform ist in der schematischen Darstellung von **Fig. 1B** zu erkennen. Dabei zeigt Fig. 1B eine perspektivische Ansicht eines schematischen Querschnitts des Resonators von Fig. 1A. Hierbei ist zu erkennen, dass die beiden Elektroden 16a, 16b auf einer zumindest bereichsweise im Wesentlichen planaren Substratgrenzfläche des Trägersubstrats 14 mit einem gegenseitigen Abstand von beispielsweise etwa 500 nm angeordnet sind. Der Schwingungsabschnitt des Schwingungselements ist vom Trägersubstrat in der gezeigten Ausführungsform etwa 250 nm bis 350 nm beabstandet und aus der in Fig. 1B dargestellten Ruhelage insbesondere in Substratnormalenrichtung (z-Richtung in Fig. 1B) rückstellfähig bzw. elastisch auslenkbar. Die vorzugsweise vorhandene Zugverspannung im Schwingungselement in dessen Längsrichtung (y-Richtung in Fig. 1 B) führt zu einer Rückstellkraft im Schwingungsabschnitt des Schwingungselement zur Ruhelage hin.

Wie in Fig. 1A außerdem dargestellt, umfasst der Resonator 10 vorzugsweise einen elektrischen Signalgeber 18, welcher elektrisch leitfähig mit der ersten Elektrode 16a und der zweiten Elektrode 16b verbunden ist. Der elektrische Signalgeber 18 ist dabei ausgelegt, eine elektrische Spannung zwischen den beiden Elektroden 16a, 16b zu variieren. Vorzugsweise ist diese Spannung als eine Überlagerung bzw. Summe *V* = *V₀ + V(t)* aus einer im Wesentlichen konstanten Vorspannung *V₀* und einer sich zeitlich ändernden, insbesondere periodischen Spannung *V(t)*, deren zeitlicher Mittelwert verschwindet, d.h. Null ist. Durch diese elektrischen Spannung wird ein elektrisches Feld erzeugt, das sich aus einem zeitlich im Wesentlichen konstanten elektrischen Vorspannungsfeld und einem zeitlich veränderlichen, insbesondere periodischen Wechselfeld zusammensetzt. Die Feldverteilung hängt dabei insbesondere von der Anordnung und/oder Geometrie der Elektroden 16a, 16b ab.

In einer bevorzugten Ausführungsform weist das Schwingungselement eine Dicke in Substratnormalenrichtung (z-Richtung in Fig. 1B) von etwa 100 nm und eine bevorzugte Breite parallel zur Substratgrenzfläche und senkrecht zur Längsrichtung, also in x-Richtung von Fig. 1B von etwa 250 nm auf. Der Resonator ist in Bezug auf die Dimensionierungen allerdings nicht auf diese bevorzugten Ausführungsformen beschränkt. In weiteren bevorzugten Ausführungsformen liegt das Verhältnis zwischen dem Abstand der beiden Elektroden und dem Abstand des Schwingungselements bzw. des Schwingungsabschnitt von der gemeinsamen Ebene der beiden Elektroden in einem Bereich von etwa 0,1 bis etwa 100, vorzugsweise in einem Bereich von etwa 1 bis etwa 10.

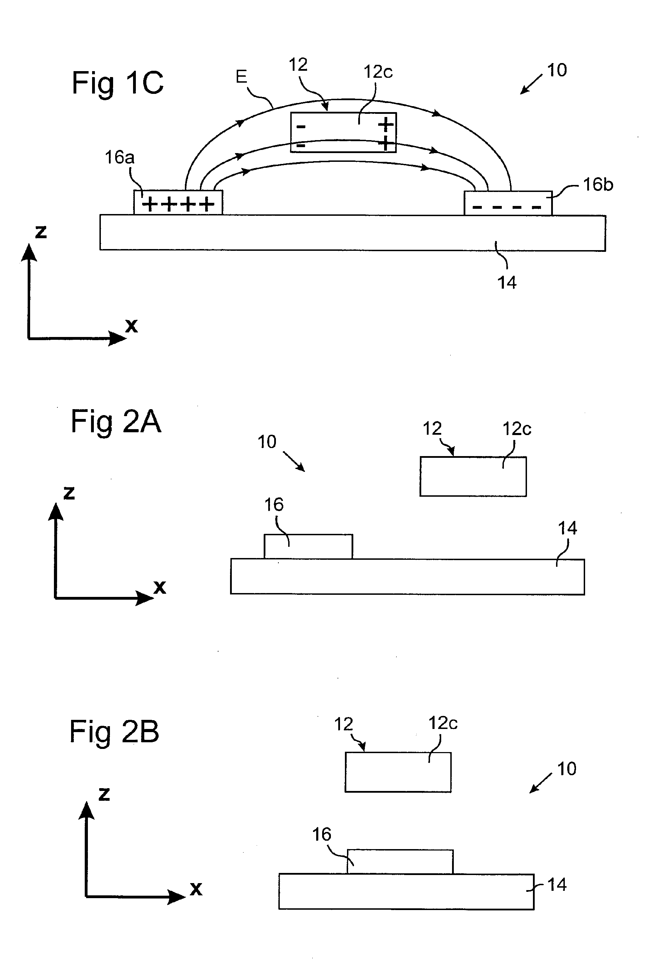

Eine schematische Darstellung des Verlaufs der Feldlinien bei einer angelegten Spannung gemäß der ersten bevorzugten Ausführungsform ist in **Fig. 1C** gezeigt. Wie aus Fig. 1C zu erkennen ist, ergeben sich insbesondere außerhalb eines zentralen Bereichs bzw. außerhalb einer geraden Verbindungslinie zwischen den beiden Elektroden 16a, 16b gekrümmte Feldlinien des elektrischen Feldes E. In diesem Bereich ist das elektrische Feld inhomogen, d.h. es ergibt sich ein nicht verschwindender Gradient, also eine Ortsabhängigkeit des elektrischen Feldes. Durch die Anordnung des Schwingungselements 12, insbesondere des Schwingungsabschnitts 12c zumindest bereichsweise außerhalb einer geraden Verbindungslinie zwischen den Elektroden 16a, 16b befindet sich der Schwingungsabschnitt 12c im Bereich des inhomogenen elektrischen Feldes. Während das elektrische Feld als solches zu einer Polarisation des vorzugsweise elektrisch isolierenden aber polarisierbaren Schwingungselements 12 führt, erzeugt der Gradient des elektrischen Feldes eine resultierende Kraft auf das polarisierte Schwingungselement 12. In der Darstellung von Fig. 1C wirkt diese Kraft in negative z-Richtung, also in Richtung des Bereichs zwischen den beiden Elektroden 16a, 16b. Durch eine Variation der elektrischen Spannung zwischen den beiden Elektroden wird das elektrische Feld und damit die Kraft auf das Schwingungselement variiert, wodurch eine Oszillation des Schwingungselements 12 angeregt wird.

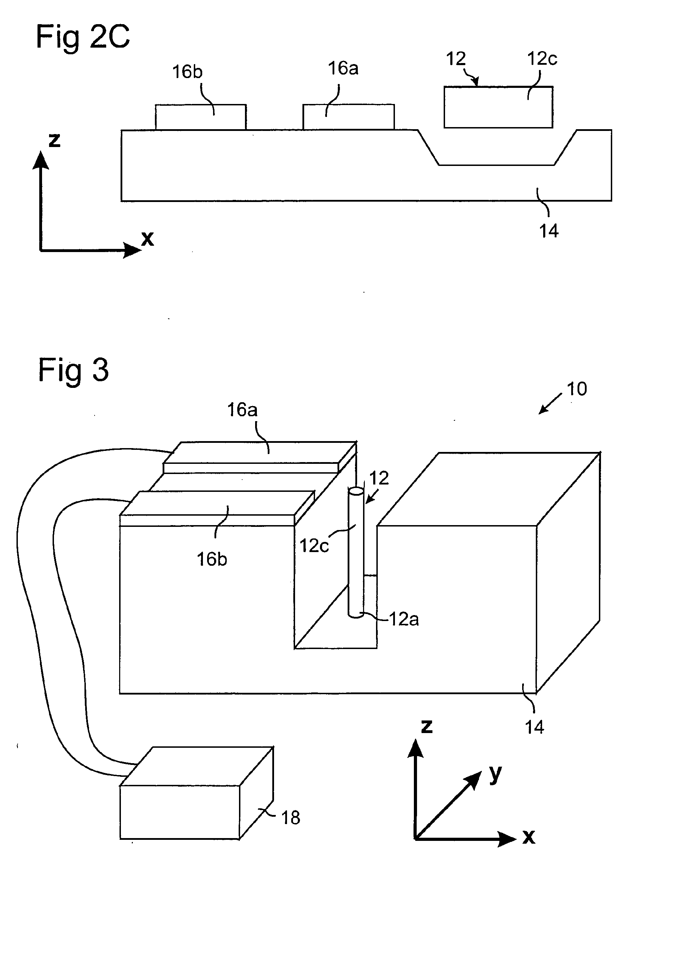

In **Fig. 2A bis 2C** sind weitere bevorzugte Ausführungsformen eines Resonators gemäß der vorliegenden Erfindung schematisch dargestellt. Dabei zeigen Fig. 2A und Fig.2B Resonatoren mit nur jeweils einer Elektrode 16 in verschiedenen Anordnungen relativ zum Schwingungselement 12. In dieser Ausführungsform wird der Resonator vorzugsweise derart betrieben, dass die zumindest eine Elektrode 16 kapazitiv an eine externe Elektrode koppelt und zusammen mit dieser ein zumindest teilweise bzw. bereichsweise inhomogenes elektrisches Feld erzeugt, wobei die externe Elektrode als Gegenelektrode zu der zumindest einen Elektrode 16 fungiert und beispielsweise als zumindest eine Teil eines Gehäuses ausgelegt sein könnte. In der Ausführungsform von Fig. 2C umfasst der Resonator 12 zwei Elektroden 16a, 16b, die entgegen der ersten Ausführungsform von Fig. 1 in einer gemeinsamen Ebene (x-y-Ebene mit den Schwingungsabschnitt 12c des Schwingungselements 12 angeordnet sind. Allerdings ist das Schwingungselement 12 auch hier in einem Bereich angeordnet, in dem ein von den Elektroden 16a, 16b erzeugtes elektrisches Feld eine starke Inhomogenität aufweist.

In einer weiteren bevorzugten Ausführungsform ist die erste und/oder zweite Elektrode 16a, 16b als zumindest ein Teil des Trägersubstrates 14 ausgebildet. Besonders bevorzugt umfasst dazu das Trägersubstrat 14 einen elektrisch leitfähigen Abschnitt, welcher als zweite Elektrode 16b ausgebildet ist, während die erste Elektrode 16a durch eine elektrische isolierende Schicht gegen den leitfähigen Teil des Trägersubstrats 14 isoliert ist. Beispielsweise umfasst das Trägersubstrat elektrisch leitfähiges Silizium als zweite Elektrode 16b und eine elektrische isolierende Schicht aus Siliziumoxid, welche die erste Elektrode 16a vom Silizium des Trägersubstrats trennt.

**Fig. 3** zeigt eine perspektivische Darstellung eines Resonators 10 gemäß einer weiteren bevorzugten Ausführungsform. In dieser Ausführungsform ist das Schwingungselement 12 in seiner Längsrichtung im Wesentlichen parallel zur Substratnormalenrichtung des Trägersubstrats 14 angeordnet. Das Schwingungselement 12 ist nur über einen Endabschnitt 12a fest mit dem Trägersubstrat 14 verbunden, während ein zweites, dem Trägersubstrat 14 abgewandtes bzw. vom Trägersubstrat 14 hochragendes Ende schwingen kann und den Schwingungsabschnitt 12c des Schwingungselements 12 bildet. Das freie Ende bzw. der Schwingungsabschnitt 12c ist in einem Bereich eines von den Elektroden 16a, 16b erzeugten inhomogenen elektrischen Feldes bewegbar. Aufgrund der Elastizität des Schwingungselements 12 und der dadurch bewirkten Rückstellkraft weist der Schwingungsabschnitt 12c eine Ruhelage auf, aus der er bei Anlegen einer elektrischen Spannung zwischen den Elektroden ausgelenkt wird. Vorzugsweise weist das Schwingungselement 12 analog zu den bereits beschriebenen Ausführungsformen zumindest eine Resonanzfrequenz f₀ auf, welche durch eine Variation bzw. Veränderung der elektrischen Spannung zwischen den Elektroden 16a, 16b angeregt wird.

In dieser "vertikalen" Anordnung des Schwingungselements 12 in der in Fig. 3 gezeigten Ausführungsform ist aufgrund des geringeren lateralen Platzbedarfs auf dem Trägersubstrat 14 eine höhere Integrationsdichte insbesondere für eine Vielzahl von Resonatorelementen auf dem selben Trägersubstrat möglich. Für weitere Details über die Ausgestaltung der einzelnen Komponenten bzw. die Funktionsweise und die Verwendung des Resonators 10 gilt das im Zusammenhang mit den anderen beschriebenen Ausführungsformen entsprechend.

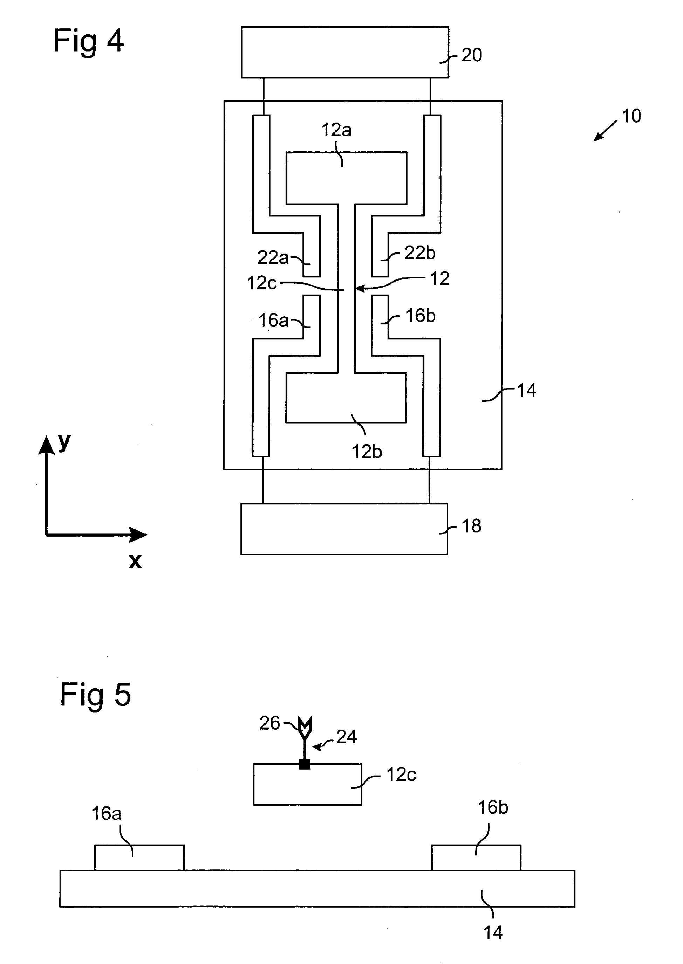

Gemäß der weiteren in **Fig. 4** dargestellten Ausführungsform umfasst der Resonator 10 außerdem eine Detektionseinrichtung 20, 22a, 22b, welche eine erste Detektionselektrode 22a und eine zweite Detektionselektrode 22b als elektrische Detektionselemente sowie eine Auswerteschaltung 20 umfasst, die eine Signalverbindung zu den Detektionselektroden 22a, 22b aufweist. Analog zu der Schwingungsanregung über die Elektroden 16a, 16b lässt sich über eine an den Detektionselektroden 22a, 22b angelegte im Wesentlichen zeitlich konstante Gleichspannung oder durch eine an den Detektionselektroden 22a, 22b bereitgestellte im Wesentlichen zeitlich konstante elektrische Ladung eine Polarisation des Schwingungselements 12 bewirken. Allerdings erfolgt vorzugsweise keine elektrische Anregung des Schwingungselements über die Detektionselektroden. Statt dessen bewirkt eine Schwingung des polarisierten Schwingungselements einen Stromfluss bzw. eine Potentialvariation auf den Detektionselektroden 22a, 22b, welche über die Signalverbindung von der Auswerteschaltung 20 erfasst bzw. detektiert wird. Eine unerwünschte bzw. parasitäre Kopplung bzw. ein Übersprechen der elektrischen Anregung von den Elektroden 16a, 16b auf die Detektionselektroden 22a, 22b wird vorzugsweise dadurch von der Detektion einer tatsächlichen Schwingung des Schwingungselements unterschieden und im detektierten Signal davon getrennt, dass die Anregung vorzugsweise bei einer Anregungsfrequenz *fₑ* erfolgt, die sich von der angeregten und zu detektierenden Resonanzfrequenz *fᵣ* des Schwingungselements 12 unterscheidet.

**Fig. 5** zeigt einen Sensor, welcher insbesondere als Massensensor und/oder zur Detektion bestimmter Partikel bzw. einer bestimmten Substanz verwendet werden kann. Damit stellt die Erfindung insbesondere einen Massensensor und/oder eine chemischen bzw. biologischen Sensor bereit. Vorzugsweise umfasst der Sensor einen erfindungsgemäßen Resonator 12 insbesondere in einer der beschriebenen Ausführungsformen. Für Details zu dessen bevorzugter Ausgestaltung wird insbesondere auf die Beschreibung zu den entsprechenden Ausführungsformen verwiesen. Zusätzlich umfasst der Sensor ein Ankerelement 24 bzw. einen Rezeptor, welcher am Schwingungselement angeordnet bzw. befestigt ist und ein Ankoppeln bzw. Verankern eines insbesondere für das Ankerelement spezifischen Partikels ermöglicht bzw. vermittelt. Dazu weist das Ankerelement 24 vorzugsweise an einem freien Endabschnitt eine funktionale Gruppe 26 auf, die selektiv an einen bestimmten Typ von Partikeln koppelt. Durch die Kopplung eines Partikels mit einer bestimmten Masse an das Schwingungselements mittels des Ankerelements wird die für eine Resonanz in Schwingung zu versetzende Masse erhöht, wodurch die Resonanzfrequenz des Resonators im Vergleich zu einem Zustand ohne diese Kopplung sinkt. Aus der Änderung bzw. Absenkung der Resonanzfrequenz lässt sich die Anwesenheit und vorzugsweise auch die Masse eines gekoppelten Partikels ermitteln. Besonders bevorzugt wird ein solcher Sensor als Gassensor verwendet. Insbesondere wird durch eine gasförmige Umgebung die Schwingung des Schwingungselements nur unwesentlich beeinträchtigt.

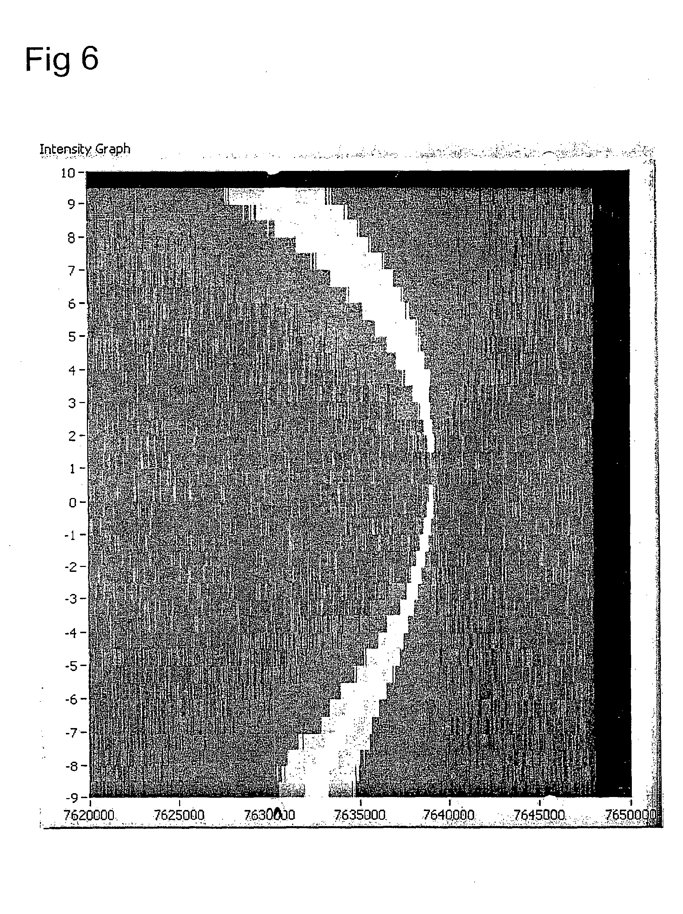

**Fig. 6** zeigt eine Graustufendarstellung einer gemessenen Schwingungsamplitude eines Schwingungselements in einem Resonator gemäß einer bevorzugten Ausführungsform. Eine hellere Farbcodierung stellt dabei eine größere Schwingungsamplitude dar. Die Schwingung wurde dabei mit einer auf der Abszisse (horizontale Achse) aufgetragenen Anregungsfrequenz *fₑ* im Bereich von 7,62 MHz bis etwa 7,65 MHz angeregt. An der Ordinate (vertikale Achse) ist die während der Anregung bereitgestellte elektrische Vorspannung *V₀* im Bereich von -9V bis +9,5V aufgetragen. Wie aus dem Verlauf des hellen Bereichs zu erkennen, hängt die Resonanzfrequenz von der elektrischen Vorspannung *V₀* ab. Insbesondere sinkt die Resonanzfrequenz *fᵣ* mit steigendem Betrag der Vorspannung *V₀*.

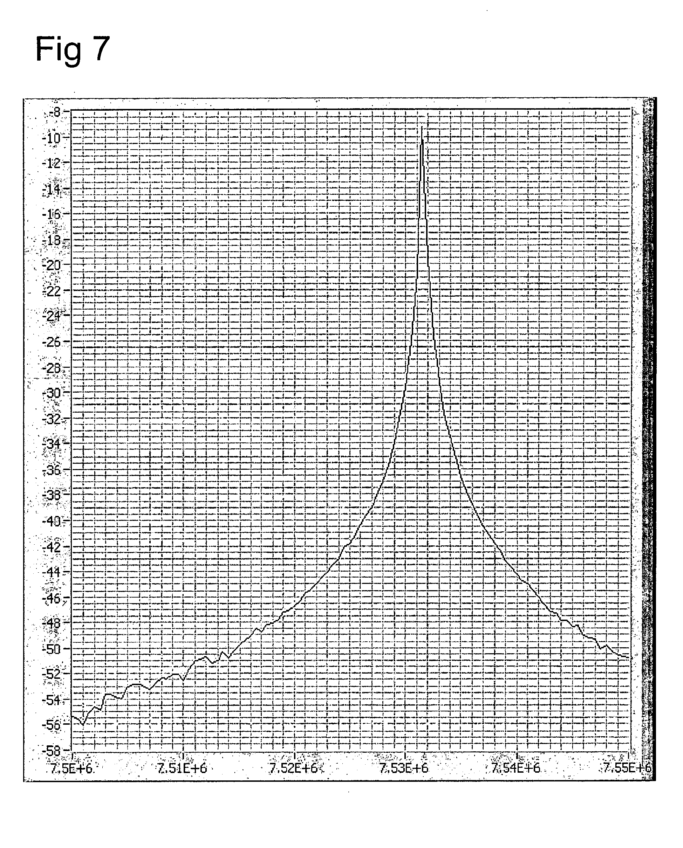

**Fig. 7** zeigt einen gemessenen Verlauf der Schwingungsamplitude (in dBm angetragen an der Ordinate) eines Schwingungselements in einem Resonator gemäß einer bevorzugten Ausführungsform in Abhängigkeit von der Anregungsfrequenz bzw. Antriebsfrequenz *fₑ* im Bereich von 7.50 MHz bis 7,55 MHz (Abszisse). Die Anregungsleistung beträgt hierbei -70 dBm. Sogar bei einer Antriebsleistung bzw. Anregungsleistung von etwa -120 dBm (10⁻¹⁵ Watt) lässt sich eine Schwingung detektieren. Die Detektion erfolgte hierbei optisch.

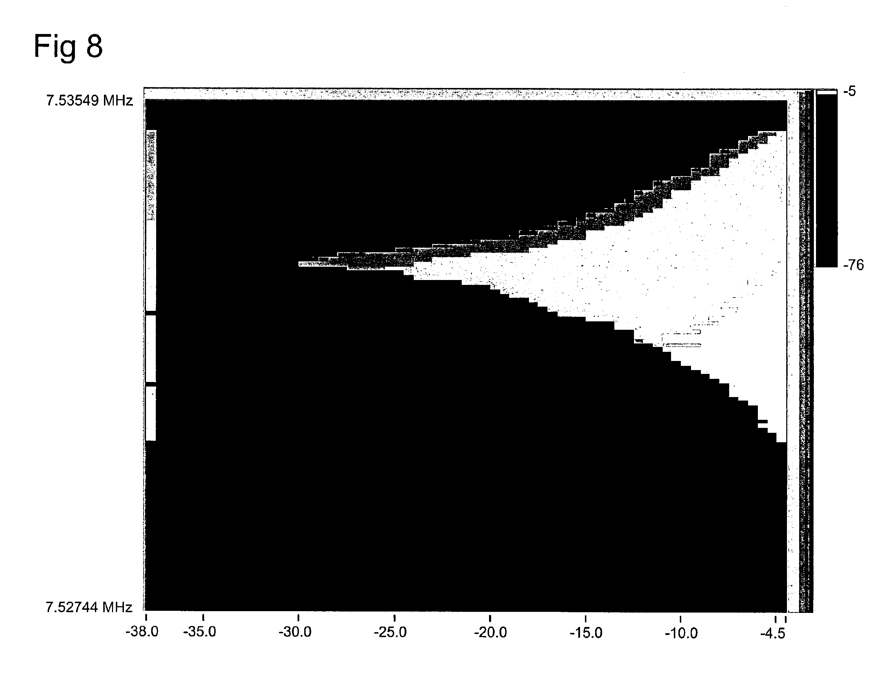

**Fig. 8** zeigt eine Graustufendarstellung einer gemessenen Schwingungsamplitude in Abhängigkeit der Anregungsfrequenz und der Anregungsleistung. Dabei ist an der Abszisse die Anregungsleistung im Bereich von -38 dBm bis etwa -4,5 dBm aufgetragen. Auf der Ordinate ist die halbe Anregungsfrequenz *fₑ*/2 im Bereich von etwa 7,5274 MHz bis etwa 7,5355 MHz in einer linearen Skala in der Frequenz aufgetragen. Die tatsächliche Anregungsfrequenz lag dabei etwa bei der doppelten Resonanzfrequenz. Aufgrund des Effekts einer parametrischen Oszillation kann auch bei einer Anregungsfrequenz im Bereich der doppelten Resonanzfrequenz eine Schwingung mit der Resonanzfrequenz effizient angeregt werden. Eine hellere Farbcodierung entspricht in der Darstellung einer größeren Schwingungsamplitude. Die Detektion erfolgte dabei optisch. Wie aus Fig. 8 zu entnehmen beträgt die minimale Antriebsstärke bzw. Anregungsleistung, die in diesem Fall noch zu einer detektierbaren spontanen Oszillation führt etwa -30 dBm (1 µW).

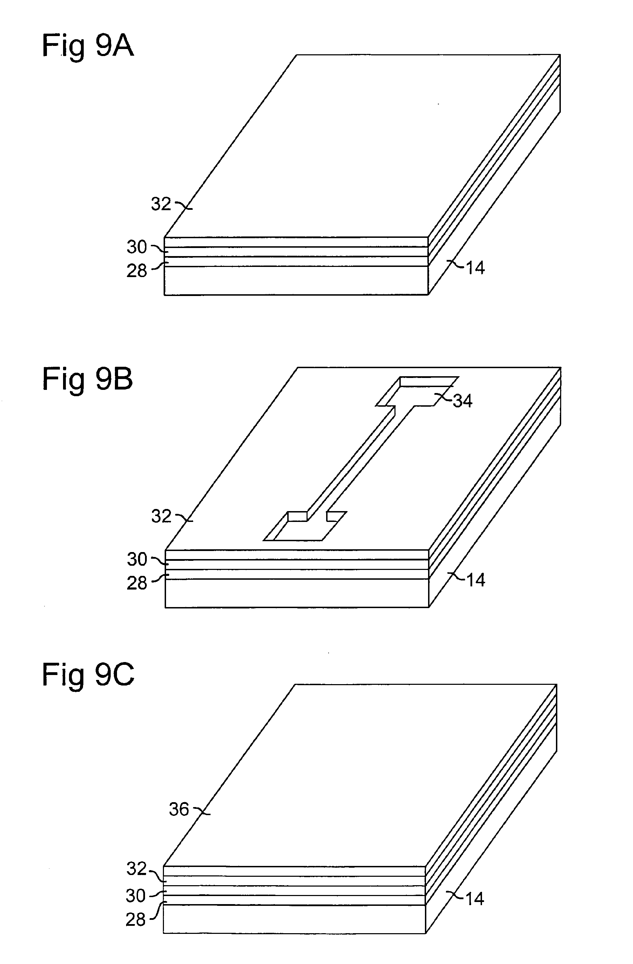

In Fig. 9A bis 9F sind einzelne Zwischenschritte eines Herstellungsverfahrens einer erfindungsgemäßen Vorrichtung in einer bevorzugten Ausführungsform schematisch dargestellt. Dabei wird, wie in **Fig. 9A** gezeigt, zunächst das Trägersubstrat 14 bereitgestellt. Als Trägersubstrat 14 könnte insbesondere ein Siliziumsubstrat, z.B. in Form eines Silizium-Wafers, verwendet werden. Auf diesem Trägersubstrat 14 werden nacheinander bzw. übereinander eine Opferschicht 28, eine Resonatormaterialschicht 30 und eine Schicht Fotolack 32 angeordnet. Beispielsweise umfasst die Opferschicht 300 nm Siliziumdioxid, auf dem beispielsweise eine etwa 100 nm dicke Siliziumnitrid-Schicht als Resonatormaterialschicht 30 angeordnet wird.

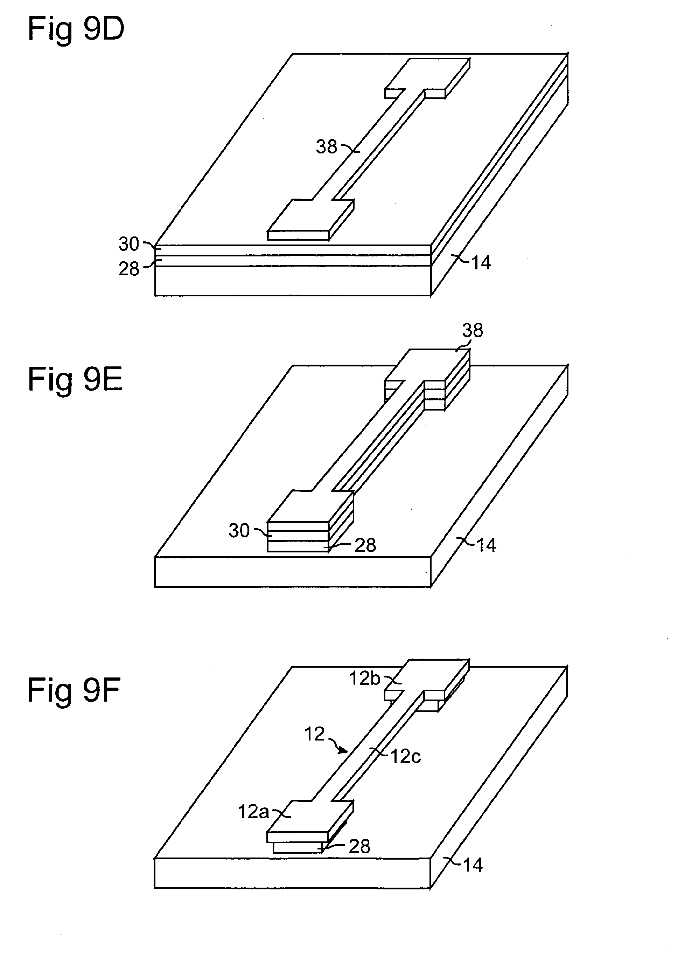

Anschließend wird die Fotolackschicht 32, wie in **Fig. 9B** dargestellt, unter Bildung einer Ätzmaskenöffnung 34 lithographisch strukturiert. Insbesondere wird die Ätzmaskenöffnung 34 im Wesentlichen in Form des Querschnitts des herzustellenden Schwingungselements ausgebildet. Hierauf wird, wie **Fig. 9C** zeigt, eine Ätzmaskenschicht 36 abgeschieden, welche beispielsweise Metall, insbesondere Aluminium umfasst. Wie in **Fig. 9D** dargestellt, bleibt nach einem weiteren Lift-off-Schritt eine Ätzmaske 38 auf der Resonatormaterialschicht 30 zurück.

Mit Hilfe dieser Ätzmaske 38 wird vorzugsweise in zwei Ätzschritten das Schwingungselement 12 ausgebildet. Dabei umfasst vorzugsweise der erste Ätzschritt einen anisotropen, also gerichteten Ätzprozess (z.B. mittels CF₄ als Ätzgas). Dabei wird, wie in **Fig. 9E** gezeigt, beispielsweise durch reaktives Ionenätzen bzw. einen Trockenätzschritt im Wesentlichen vertikal, d.h. in Substratnormalenrichtung in die Schichtstruktur hineingeätzt und dabei werden insbesondere die nicht von der Ätzmaske 38 abgedeckten Bereiche der Resonatormaterialschicht 30 und der Opferschicht 28 abgetragen. In einem nachfolgenden isotropen Ätzprozess, beispielsweise einem Nassätzschritt unter Verwendung von gepufferter Flusssäure, wird die Ätzmaske 38 vollständig und die Opferschicht 28 teilweise abgetragen. Durch die Wahl der richtigen Ätzzeit wird vorzugsweise die Opferschicht 28 unter dem als Balken oder Saite ausgebildeten Schwingungsabschnitt 12c des Schwingungselements 12 vollständig entfernt, während unter den mit größerem Querschnitt ausgebildeten Endabschnitten 12a, 12b die Opferschicht 28 zumindest noch teilweise verbleibt und damit eine feste Verbindung des Schwingungselements 12 zum Trägersubstrat 14 bildet, wie in **Fig. 9F** dargestellt.

Anschließend können noch die beispielsweise bereits in Fig. 1 gezeigten Elektroden 16a, 16b auf dem Trägersubstrat angeordnet werden. In einer anderen Ausführungsform könnten die Elektroden auch vor dem Ausbilden des Schwingungselement hergestellt bzw. am Trägersubstrat angeordnet werden.

Der erfindungsgemäße Resonator bzw. Sensor bzw. Taktgeber ist nicht auf die in Zusammenhang mit den beispielhaft beschriebenen bevorzugten Ausführungsformen gezeigten Geometrien und/oder Materialien beschränkt.

Insbesondere ist das Schwingungselement nicht auf eine Geometrie beschränkt, welche in einer räumlichen Dimension deutlich größer ist als in den beiden anderen räumlichen Dimensionen. Der Schwingungsabschnitt ist dabei nicht auf eine Geometrie nach Art einer Saite oder eines Balkens oder eines Stegs beschränkt. In einer anderen bevorzugten Ausführungsform ist das Schwingungselement flächig nach Art einer Membran ausgebildet. In dieser Ausführungsform weist das Schwingungselement in zwei räumlichen Dimensionen eine deutlich größere Ausdehnung aus als in der dritten Dimension, wobei das Schwingungselement vorzugsweise im Wesentlichen in Richtung dieser dritten Dimension schwingungsfähig aus einer Ruhelage auslenkbar ist.

### Bezugszeichenliste

- 10: Resonator
- 12: Resonatorelement
- 12a, 12b: erster, zweiter Endabschnitt des Resonatorelements
- 12c: Schwingungsabschnitt des Resonatorelements
- 14: Trägersubstrat
- 16a, 16b: erste, zweite Elektrode
- 16: erste Elektrode
- 18: elektrischer Signalgeber
- 20: Auswerteschaltung
- 22a, 22b: erste, zweite Detektionselektrode
- 24: Ankerelement
- 26: funktionale Gruppe
- 28: Opferschicht
- 30: Resonatormaterialschicht
- 32: Fotolack
- 34: Ätzmaskenöffnung
- 36: Ätzmaskenschicht
- 38: Ätzmaske

## Patentansprüche

1. Resonator (10), umfassend:
- zumindest eine erste Elektrode (16, 16a) zur Erzeugung eines zumindest bereichsweise inhomogenen, elektrischen Feldes (E);
- ein Schwingungselement (12), das zumindest bereichsweise in dem inhomogenen elektrischen Feld (E) der zumindest einen ersten Elektrode (16, 16a) angeordnet ist und in Richtung des Feldgradienten des inhomogenen elektrischen Feldes (E) rückstellfähig auslenkbar ist; und
- einen elektrischen Signalgeber (18), welcher ausgelegt ist, das elektrische Potential der zumindest einen ersten Elektrode (16, 16a) zu variieren.

2. Resonator (10) nach Anspruch 1, wobei das Schwingungselement (12) von einem homogenen Material gebildet ist.

3. Resonator (10) nach Anspruch 1 oder 2, wobei das Schwingungselement (12) elektrisch isolierendes Material umfasst.

4. Resonator (10) nach einem der vorangegangenen Ansprüche, wobei das Schwingungselement (12) Material mit einer Dielektrizitätskonstante von mindestens 2, vorzugsweise mindestens 3, besonders bevorzugt in einem Bereich von 3 bis 15, am meisten bevorzugt in einem Bereich von 5 bis 10 umfasst.

5. Resonator (10) nach einem der vorangegangenen Ansprüche, wobei das Schwingungselement (12) über einen ersten Endabschnitt (12a) und einen zweiten Endabschnitt (12b) an einem Trägersubstrat (14) befestigt ist und zumindest in einem zwischen den beiden Endabschnitten angeordneten Schwingungsabschnitt (12c) zugverspannt ist.

6. Resonator (10) nach einem der vorangegangenen Ansprüche, wobei das Schwingungselement (12) eine Resonanzfrequenz *fᵣ* von mindesten 1 kHz, vorzugsweise mindestens 10 kHz, noch mehr bevorzugt mindestens 0,1 MHz, am meisten bevorzugt mindestens 1 MHz aufweist.

7. Resonator (10) nach einem der vorangegangenen Ansprüche, welcher außerdem zumindest eine zweite Elektrode (16b) umfasst, welche ausgelegt ist, zusammen mit der zumindest einen ersten Elektrode (16a) das zumindest bereichsweise inhomogene, elektrische Feld (E) zu erzeugen.

8. Resonator (10) nach einem der vorangegangenen Ansprüche, wobei das Schwingungselement (12) von der ersten Elektrode (16, 16a) und/oder zweiten Elektrode (16b) einen Abstand von höchstens 10 µm, vorzugsweise höchstens 5 µm, besonders bevorzugt höchstens 2 µm, noch mehr bevorzugt höchstens 1 µm und am meisten bevorzugt höchstens 0,5 µm aufweist.

9. Resonator (10) nach einem der vorangegangenen Ansprüche, außerdem umfassend eine Detektionseinrichtung (20, 22a, 22b) zum Detektieren einer Schwingung des Schwingungselements (12).

10. Sensor umfassend
- zumindest einen Resonator (10) gemäß einem der Ansprüche 1 bis 9; und
- zumindest ein am Schwingungselement (12) angeordnetes Ankerelement (24) zur Verankerung eines zu detektierenden Partikels am Schwingungselement (12).

11. Verwendung eines Resonators (10) nach einem der Ansprüche 1 bis 9 als Frequenzfilter.

12. Taktgeber, welcher einen Resonator (10) nach einem der Ansprüche 1 bis 9 umfasst, wobei der elektrische Signalgeber (18) als elektrischer Schwingkreis ausgebildet ist, der ausgelegt ist, das elektrische Potential der zumindest einen ersten Elektrode breitbandig zu variieren.

13. Verfahren zur Resonanzerzeugung durch zeitliches Variieren eines inhomogenen elektrischen Feldes in zumindest einem Bereich eines mechanischen Schwingungselements (12).

14. Verfahren nach Anspruch 13, wobei das zeitliche Variieren eines inhomogenen elektrischen Feldes (E) ein Anlegen einer elektrischen Spannung zwischen einer ersten Elektrode (16a) und einer zweiten Elektrode (16b) derart umfasst, dass die elektrische Spannung mit einer Anregungsfrequenz *fₑ* um eine im Wesentlichen konstante Vorspannung *V₀* herum periodisch variiert wird, wobei die Anregungsfrequenz *fₑ* zu einer Resonanzfrequenz *fᵣ* des Schwingungselements (12) im Verhältnis n/m mit ganzen Zahlen m und n steht.

15. Verfahren zur Detektion und/oder Messung einer Beschleunigung umfassend:
- Anregen einer Resonanzschwingung eines mechanischen Schwingungselements (12) durch zeitliches Variieren eines inhomogenen elektrischen Feldes (E) in zumindest einem Bereich des mechanischen Schwingungselements (12);
- Erfassen einer Frequenzänderung der Resonanzschwingung während der Beschleunigung;
- Ermitteln der Beschleunigung in Abhängigkeit von bzw. aus der erfassten Frequenzänderung.
